# EUROPÄISCHE PATENTANMELDUNG

(11) **EP 0 996 229 A2**
(43) Veröffentlichungstag der Anmeldung: **26.04.2000**
(21) Anmeldenummer: 99119290.7
(22) Anmeldetag: 28.09.1999
(51) Int. Cl.: H03K 19/00, G06F 5/06, G11C 7/10, H03K 3/02, H03K 19/017, H03K 19/0175

(54) **Elektronische Schaltungsanordnung mit einer Umlaufspeicherschaltung (FIFO)**

(30) Priorität: 08.10.1998 DE 19846454
(71) Anmelder: SIEMENS AKTIENGESELLSCHAFT, 80333 München (DE)
(72) Erfinder: Johnson, Bret, 81737 München (DE)

(57) **Zusammenfassung**

Die Erfindung bezieht sich auf eine elektronische Schaltungsanordnung mit einer einen Dateneingang (7) und einen Datenausgang (8) aufweisenden Umlaufspeicherschaltung (FIFO) (1), bei der in einer Betriebsart Speichermodus die am Dateneingang anliegenden Daten zwischengespeichert sind. Dabei ist zwischen dem Dateneingang (7) und dem Datenausgang (8) der Umlaufspeicherschaltung (1) eine Brückenschaltung (11) vorgesehen, die über ein Auswahlsignal in einer Betriebsart Direktmodus eine unmittelbare, verzögerungsfreie Übertragung der Daten auf den Datenausgang (8) steuert.

## Beschreibung

Die Erfindung bezieht sich auf eine elektronische Schaltungsanordnung mit einer einen Dateneingang und einen Datenausgang aufweisenden Umlaufspeicherschaltung (FIFO), bei der in einer Betriebsart Speichermodus die am Dateneingang anliegenden Daten zwischengespeichert sind.

Zwischenspeicher in Form von FIFO oder Umlaufspeicherschaltung finden vielfältige Anwendungen. Zum Beispiel bei Speicherbausteinen, bei denen mit synchronen und asynchronen Betriebsarten gearbeitet wird. Die beim synchronen Betriebsmodus auftretenden Zeitverschiebungen werden durch den FIFO-Zwischenspeicher ausgeglichen. In einem asynchronen Betriebsmodus ist diese Zwischenspeicherung nicht notwendig. In bisherigen Lösungsansätzen wurde der FIFO-Speicher im asynchronen Betriebsmodus in eine Art neutralen Zustand versetzt, in dem die Daten nicht zwischengespeichert, sondern durch die FIFO-Schaltung hindurch geschleust wurden, indem die Eingangs- und Ausgangsstufen einer Datenspeicherzelle des FIFO-Speichers geöffnet wurden. Von Nachteil hierbei hat sich ausgewirkt, dass eine Signalverzögerung durch die Laufzeit innerhalb des deaktivierten FIFO-Bausteins entstand.

Der Erfindung liegt die Aufgabe zugrunde, die Laufzeiten innerhalb des FIFO-Bausteins zu verringern.

Diese Aufgabe wird durch eine elektronische Schaltungsanordnung nach Anspruch 1 gelöst.

Erfindungsgemäß ist vorgesehen, dass zwischen dem Dateneingang und dem Datenausgang der Umlaufspeicherschaltung eine Brückenschaltung vorgesehen ist, die über ein Auswahlsignal in einer Betriebsart Direktmodus eine unmittelbare, verzögerungsfreie Übertragung der Daten auf den Datenausgang steuert.

Die Erfindung schlägt vor, die Verzögerungslaufzeiten innerhalb der Umlaufspeicherschaltung dadurch zu minimieren, dass ein Bypass zum Datenspeicherzellenblock der FIFO-Schaltung vorgesehen ist, der je nach Betriebsart Direktmodus oder Speichermodus den FIFO-Speicher umgeht.

Dem Prinzip der Erfindung folgend ist die Brückenschaltung durch einen zwischen dem Dateneingang und dem Datenausgang und parallel zur Umlaufspeicherschaltung angeordneten Schalter ausgebildet.

In einer besonders bevorzugten Ausführung der Erfindung ist dieser Schalter zwischen dem Dateneingang und dem Datenausgang durch einen Dreizustands-Buffer ausgebildet, der dann in der Betriebsart Direktmodus auf Durchgang geschaltet ist.

In einer besonders bevorzugten Ausführung der Erfindung ist die Umlaufspeicherschaltung mit mehreren gleichartig ausgebildeten Datenspeicherzellen, denen eingangsseitig und ausgangsseitig jeweils eine Ansteuerschaltung zugeordnet sind, die ihrerseits wieder jeweils durch eine Flipflop-Stufe angesteuert werden, versehen.

In einer weiterhin bevorzugten Ausführung der Erfindung sind diese Flipflop-Stufen, die die Ansteuerschaltung eingangsseitig und ausgangsseitig ansteuern, durch eine Trigger-Flipflop-Schaltung ausgebildet, deren Vorbereitungseingänge also zusammengeschaltet angesprochen werden.

In einer zweckmäßigen Ausführung der Erfindung ist dem Eingang der Datenspeicherzellen ein Inverter vorgeschaltet. Dem Prinzip der Erfindung folgend werden die Dateninhalte der Datenspeicherzellen über einen Dreizustands-Buffer ausgegeben, der in der Betriebsart Speichermodus vermittels eines Aktivierungssignals auf Durchgang geschaltet ist, und mit dem Datenausgang verbunden ist.

In einer zweckmäßigen Ausgestaltung der elektronischen Schaltungsanordnung ist der Takteingang der eingangsseitigen Flipflop-Stufe mit dem Eingabetakteingang und der Takteingang der ausgangsseitigen Flipflop-Stufe mit dem Ausgabetakteingang der elektrischen Schaltungsanordnung verbunden. Weiterhin von Vorteil ist, wenn die erste und/oder zweite Ansteuerschaltung durch UND-Gatter und einen Inverter ausgebildet ist.

In einer bevorzugten Ausführung der Erfindung kann die Umlaufspeicherschaltung vermittels eines Wahlsignals in eine dritte Betriebsart, einen Verzögerungsmodus versetzt werden, bei dem die Daten durch eine Datenspeicherzelle geschleust werden, die Umlaufspeicherschaltung also als Verzögerungsstufe ohne Zwischenspeicherung der am Dateneingang anliegenden Daten betrieben wird.

Zweckmäßige Weiterbildungen der Erfindung ergeben sich aus den Unteransprüchen.

Nachfolgend wird die Erfindung anhand eines in einer Zeichnung dargestellten Ausführungsbeispiels weiter erläutert. Es zeigt:

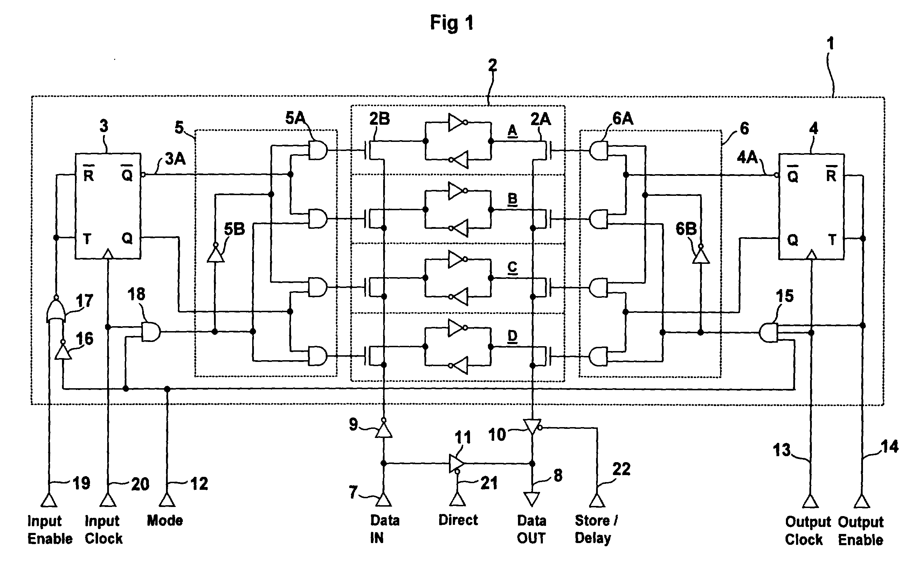

- Figur 1: ein schematisches Schaltbild einer elektronischen Schaltungsanordnung nach dem Ausführungsbeispiel der Erfindung.

Das in Figur 1 gezeigte Ausführungsbeispiel der Erfindung umfasst eine Umlaufspeicherschaltung 1 mit einem Dateneingang 7 und einem Datenausgang 8, einem Datenspeicherzellenblock 2, der aus Datenspeicherzellen A bis D ausgebildet ist, einer dem Datenspeicherzellenblock 2 eingangs- und ausgangsseitig zugeordneten Ansteuerschaltung 5 und 6, welche aus UND-Gattern und einem Inverter aufgebaut ist, sowie jeweils den eingangs- und ausgangsseitigen Ansteuerschaltungen zugeordneten Flipflop-Stufen 3 und 4, die als Trigger-Flipflops geschaltet sind. Vor den Datenspeicherzellen und nach dem Dateneingang ist ein Inverter 9 zwischengeschaltet, der eine Dateninvertierung vornimmt. Ausgangsseitig des Datenspeicherzellenblocks 2 ist ein Dreizustands-Buffer 10 vorgesehen, der ausgangsseitig mit dem Datenausgang verbunden ist. Zwischen dem Datenein- und -ausgang 7 und 8 ist vor dem Inverter 9 und nach der dem Dreizustands-Buffer 10 ein weiterer Dreizustands-Buffer 11 zwischengeschaltet, der den Dateneingang 7 direkt mit dem Datenausgang 8 verbindet. Über den Wahleingang 12 wird die Umlaufspeicherschaltung 1 in den Speicher- oder Verzögerungsmodus versetzt. Wird an ihm und zugleich an der Eingabefreigabe 19 und am Eingabetakteingang 20 eine logische Null (Asynchron-Modus) angelegt, und gleichzeitig der Ausgabetakteingang 13 und die Ausgabefreigabe 14 auf logisch Null gesetzt, so wird am Ausgang des UND-Gatters 15 eine logische Null bereitgestellt. Über den Inverter 6B der ausgangsseitigen Ansteuerschaltung 6 werden zusammen mit dem auf logisch Eins gelegten invertierenden Ausgang 4A des angehaltenen Flipflops 4 beide Eingänge des UND-Gatters 6A der ausgangsseitigen Ansteuerschaltung 6 auf logisch Eins gesetzt und demzufolge der ausgangsseitige Transistor 2A der ersten Datenspeicherzelle A des Datenspeicherzellenblocks 2 geöffnet. Des Weiteren wird durch die logische Null am Wahleingang 12 die eingangsseitige Flipflop-Stufe 3 über den Inverter 16 und das NOR-Gatter 17 deaktiviert, wodurch der invertierende Ausgang 3A des Flipflops 3, und somit der erste Eingang des UND-Gatters 5A, auf logisch Eins geht. Durch das UND-Gatter 18 wird der Null-Pegel des Wahleingangs 12 über den Inverter 5B der eingangsseitigen Ansteuerschaltung 5 als ein Eins-Pegel am zweiten Eingang des UND-Gatters 5A der eingangsseitigen Ansteuerschaltung 5 zur Verfügung gestellt, wodurch das UND-Gatter 5A den Transistor 2B öffnet. Demzufolge werden nun Daten, die am Dateneingang 7 und über den Inverter 9 invertiert worden sind, mit der Verzögerung, die durch die Konstruktion der Datenspeicherzelle A vorgegeben werden kann, auf dem Datenausgang 8 wieder ausgegeben, sofern der Dreizustands-Butter 10 für den Speicher- oder Verzögerungsmodus vermittels eines am Speichermoduswahleingang 22 anliegenden Signals auf Durchgang geschaltet worden ist.

In der zweiten Betriebsart Direktmodus wird über den Direktmodusaktivierungseingang 21 der Dreizustands-Buffer 11 aktiviert, und dementsprechend der Speichermoduswahleingang 22 deaktiviert, wodurch die Daten vom Dateneingang 7 direkt über den Dreizustands-Buffer 11 an den Datenausgang 8 verzögerungsfrei ausgegeben werden.

In der Betriebsart Speichermodus wird der Dreizustands-Buffer 11 über den Direktmodusaktivierungseingang 21 deaktiviert und der Dreizustands-Buffer 10 über den Speichermoduswahleingang 22 aktiviert. Der Wahleingang 12 muss hierbei auf logisch Eins geschaltet sein. Ist die Eingabefreigabe 19 auf einem logisch Eins-Pegel, also deaktiviert, und der Eingabetakteingang 20 auf logisch Null, so befindet sich die eingangsseitige Auswahlschaltung 5 in einem Reset-Zustand, in welchem die Datenspeicherzelle A ausgewählt, und der Transistor 2A geöffnet ist. Wird nun der Zustand der Eingabefreigabe 19 auf logisch Null geändert, werden durch die Ansteuerschaltung 5 und dem zugehörigen Flipflop 3 sequenziell die Datenspeicherzellen A bis D mit jedem neuen Takt am Eingabetakteingang 20 angewählt und mit dem am Dateneingang 7 anliegenden Daten beschreiben.

Ebenso befindet sich die ausgangsseitige Ansteuerschaltung 6 in einem Reset-Zustand, bevor auf der Ausgabefreigabe 14 ein erster Eins-Pegel anliegt. Es ist dadurch ebenfalls die Datenspeicherzelle A für eine Ausgabe angewählt. Solange die Ausgabefreigabe 14 auf logisch Eins bleibt, werden mit jedem Takt auf dem Ausgabetakteingang 13 sequenziell die Datenspeicherzellen A bis D über die ausgangsseitige Ansteuerschaltung 6 angesprochen, und die Dateninhalte der Datenspeicherzellen über den Dreizustands-Buffer 10 am Datenausgang 8 ausgegeben.

Konstruktiv bedingt muss außerhalb der Umlaufspeicherschaltung dafür Sorge getragen werden, dass die Daten der Datenspeicherzellen, hier im Beispiel vier, nicht versehentlich überschrieben werden, solange sie noch nicht ausgelesen wurden.

## Patentansprüche

1. Elektronische Schaltungsanordnung mit einer einen Dateneingang (7) und einen Datenausgang (8) aufweisenden Umlaufspeicherschaltung (FIFO) (1), bei der in einer Betriebsart Speichermodus die am Dateneingang (7) anliegenden Daten zwischengespeichert sind,
**dadurch gekennzeichnet,**
dass zwischen dem Dateneingang (7) und dem Datenausgang (8) der Umlaufspeicherschaltung (1) eine Brückenschaltung vorgesehen ist, die über ein Auswahlsignal in einer Betriebsart Direktmodus eine unmittelbare, verzögerungsfreie Übertragung der Daten auf den Datenausgang (8) steuert.

2. Elektronische Schaltungsanordnung nach Anspruch 1,
**dadurch gekennzeichnet,**
dass die Brückenschaltung durch einen zwischen dem Dateneingang (7) und dem Datenausgang (8) und parallel zur Umlaufspeicherschaltung (1) angeordneten Schalter ausgebildet ist.

3. Elektronische Schaltungsanordnung nach Anspruch 2,
**dadurch gekennzeichnet,**
dass der Schalter zwischen dem Dateneingang (7) und dem Datenausgang (8) durch einen Dreizustands-Buffer (11) ausgebildet ist, der in der Betriebsart Direktmodus auf Durchgang geschaltet ist.

4. Elektronische Schaltungsanordnung nach Anspruch 1 bis 3,
**dadurch gekennzeichnet,**
dass die Umlaufspeicherschaltung (1) durch mehrere gleichartig ausgebildete Datenspeicherzellen (A bis D) ausgebildet ist, denen eingangsseitig eine erste und ausgangsseitig eine zweite Ansteuerschaltung (5 und 6) zugeordnet ist, die jeweils durch eine Flipflop-Stufe (3 und 4) angesteuert werden.

5. Elektronische Schaltungsanordnung nach Anspruch 4,
**dadurch gekennzeichnet,**
dass die Flipflop-Stufe durch eine Trigger-Flipflop-Stufe mit zusammengeschalteten Vorbereitungseingängen ausgebildet sind.

6. Elektronische Schaltungsanordnung nach einem der Ansprüche 1 bis 5,
**dadurch gekennzeichnet,**
dass die Daten am Dateneingang (7) über einen Inverter (9) an die Datenspeicherzellen (A bis D) angelegt sind.

7. Elektronische Schaltungsanordnung nach einem der Ansprüche 1 bis 6,
**dadurch gekennzeichnet,**
dass die Dateninhalte der Datenspeicherzellen (A bis D) über einen Dreizustands-Buffer (10) ausgegeben werden, der in der Betriebsart Speichermodus vermittels eines Aktivierungssignals auf Durchgang geschaltet ist.

8. Elektronische Schaltungsanordnung nach einem der Ansprüche 3 bis 7,
**dadurch gekennzeichnet,**
dass die erste und/oder zweite Ansteuerschaltung (5 und 6) durch mindestens ein UND-Gatter und mindestens einen Inverter ausgebildet ist.

9. Elektronische Schaltungsanordnung nach Anspruch 8,
**dadurch gekennzeichnet,**
dass die Takteingänge der Flipflop-Stufen an einem Eingabetakteingang (20) und an einem Ausgabetakteingang (13) der elektronischen Schaltungsanordnung anliegen.

10. Elektronische Schaltungsanordnung nach einem der Ansprüche 1 bis 9,
**dadurch gekennzeichnet,**
dass die Umlaufspeicherschaltung (1) vermittels eines Wahlsignals (12) in eine dritte Betriebsart, einen Verzögerungsmodus versetzt wird, bei dem die Umlaufspeicherschaltung (1) als Verzögerungsstufe und ohne Zwischenspeicherung der am Dateneingang (7) anliegenden Daten betrieben wird.
